# EUROPEAN PATENT APPLICATION

(11) **EP 2 290 687 A1**
(43) Date of publication of application: **02.03.2011**
(21) Application number: 09168873.9
(22) Date of filing: 27.08.2009
(51) Int. Cl.: H01L 23/66, H01L 23/64, H01L 23/498

(54) **Designing packaged integrated circuits for reducing impedance discontinuities**

(71) Applicant: NXP B.V., 5656 AG Eindhoven (NL)
(72) Inventor: Thoonen, Hendrikus Johannes Jacobus, Redhill, Surrey RH1 1DL (GB); Buot, Rey, Redhill, Surrey RH1 1DL (GB); Nunn, Wayne, Redhill, Surrey RH1 1DL (GB); van Mil, Job, Redhill, Surrey RH1 1DL (GB); van Straten, Freek Egbert, Redhill, Surrey RH1 1DL (GB)
(74) Representative: Williamson, Paul Lewis

(57) **Abstract**

A method (200) of designing a packaged integrated circuit (100), wherein the method comprises determining (202) an electric model of the packaged integrated circuit (100), analyzing (206) a characteristic of a transmission of an electric signal by the packaged integrated circuit (100) based on the electric model, and modifying (210) the packaged integrated circuit (100) based on a result of the analyzing (206) for reducing discontinuities of a characteristic impedance of the packaged integrated circuit (100).

## Description

### FIELD OF THE INVENTION

The invention relates to a method of designing a packaged integrated circuit.

Furthermore, the invention relates to a packaged integrated circuit.

The invention further relates to a computer readable medium.

Moreover, the invention relates to a program element.

### BACKGROUND OF THE INVENTION

For instance for packaging semiconductor chips and for connecting the packaged semiconductor chip to a printed circuit board, a number of electric contacts has to be made. The ability to provide more and more input/output interconnections to a die (bare chip) that is increasingly shrinking in size is an important issue. In addition, the smaller size of the package contributes as much to the miniaturization of cellular phones and other handheld devices as the shrinking of the semiconductor circuits. Simultaneously with this trend, requirements regarding signal transmission speed continously increase which has an impact on the necessity of a high quality of the packaging of chips.

However, conventional connection techniques do not allow to provide a sufficient signal transmission quality when transmitting an electric signal between integrated circuit and package and further to an application board.

### OBJECT AND SUMMARY OF THE INVENTION

Hence, it is an object of the invention to provide a sufficient signal transmission quality when transmitting an electric signal between integrated circuit and package and further to an application board.

The object of the invention is achieved by a method of designing a packaged integrated circuit, a packaged integrated circuit, a computer readable medium, and a program element according to the independent claims.

According to an exemplary embodiment, a method of designing a packaged integrated circuit is provided, wherein the method comprises determining an electric model of the packaged integrated circuit, analyzing a characteristic of a transmission of an electric signal by the packaged integrated circuit based on the electric model, and modifying the packaged integrated circuit based on a result of the analyzing for reducing discontinuities of a characteristic impedance of the packaged integrated circuit.

According to another exemplary embodiment, a packaged integrated circuit is provided (which may be designed by a method having the above mentioned features), wherein the packaged integrated circuit may comprise an integrated circuit, a package housing the integrated circuit and being adapted for electrically coupling the integrated circuit to an application board to be mechanically connected to the packaged integrated circuit, a transmission line along which an electric signal is to be coupled between the integrated circuit and the application board, and at least one inductor (such as one or more coils which may be integrated, for example, in a semiconductor substrate of the integrated circuit and/or in a substrate of the package) configured for at least partially compensating a capacitance formed at a signal interface between the integrated circuit and the package of the packaged integrated circuit (particularly to optimize the transmission line).

According to still another exemplary embodiment of the invention, a program element (for instance a software routine, in source code or in executable code) is provided, which, when being executed by a processor, is adapted to control or carry out a method having the above mentioned features.

According to yet another exemplary embodiment of the invention, a computer-readable medium (for instance a CD, a DVD, a USB stick, a floppy disk or a harddisk) is provided, in which a computer program is stored which, when being executed by a processor, is adapted to control or carry out a method having the above mentioned features.

Data processing for hardware design purposes which may be performed according to embodiments of the invention can be realized by a computer program, that is by software, or by using one or more special electronic optimization circuits, that is in hardware, or in hybrid form, that is by means of software components and hardware components.

The term "die", "chip" or "integrated circuit" (IC) may particularly denote a naked semiconductor piece which is processed to provide one or more integrated circuit components (such as transistors, capacitors, vias, etc.) in an interior of the semiconductor body.

The term "chip package" or "package" may particularly denote a housing that chips come in for plugging into (socket mount) or soldering onto (surface mount) a circuit board such as a printed circuit board, thus creating a mounting for a chip. In electronics, the term chip package or chip carrier may denote the material added around a component or integrated circuit to allow it to be handled without damage and incorporated into a circuit. Consequently a chip in combination with a package may form a packaged chip. By packaging, a pitch of the die (for instance 15 µm) may be matched to a pitch of the package (for instance 1 mm).

The term "circuit board" (or application board) may particularly denote a support or mounting base on which a packaged chip such as a semiconductor chip is to be mounted. More particularly, printed circuit boards may be denoted as circuit boards comprising an insulator (for instance fiberglass), with threads of electrically conductive material serving as wires on the base of the board. The insulator may comprise one or numerous layers of material glued into a single entity. These additional layers may serve for a number of purposes, including providing grounding to the board. A printed circuit board, or PCB, may be used to mechanically support and electrically connect electronic components using conductive pathways, or traces, etched from copper sheets laminated onto a non-conductive substrate. A circuit board may also be a printed wiring board (PWB) or an etched wiring board. Also a leadframe may be denoted as a circuit board as used herein.

The term "electric model of the packaged integrated circuit" may particularly denote a theoretical model simulating as to how the virtual packaged integrated circuit to be designed will behave electrically. In other words, each or each sufficiently relevant component of the packaged integrated circuit can be modelled as basic electrical components such as resistors, inductors and capacitances, transistors or the like. Thus, a realistic electrical model of the packaged integrated circuit may be obtained which can also be considered as an equivalent circuit thereof. Such a model may include a parameterization of the modelled components, for instance a signal line may be characterized by a first parameter indicative of its ohmic resistance, by a second parameter indicative of its capacitance, and by a third parameter indicative of its inductance.

The term "characteristic of a transmission of an electric signal" may particularly denote that a defined electric model is taken as a basis for determining as to how a corresponding electric system would behave in reality upon transmitting of an electric signal. The characteristics in this respect may be a signal transmission time or delay, a signal quality arriving at a destination, and a distortion of a signal due to influences on the propagation path. A simulation of the behaviour may be performed on the level of the packaged integrated circuit or even on system level.

The term "modifying the packaged integrated circuit" may particularly denote that in the design of such a packaged integrated circuit, one or more components may be altered, for instance one or more components may be removed or added to such a circuit. Additionally or alternatively it may also include changing the characteristic of one of such components, for instance selecting an inductor having a different value of the inductance. In the context of a parameterized model, one or more parameters may be adjusted during such a modifying procedure.

The term "discontinuities of a characteristic impedance of the packaged integrated circuit" may particularly denote signal distortion artefacts which may occur at a transition or interface between integrated circuit and package and/or between package and a connectable application board. Such a distortion may for instance result from a parasitic capacitance at such a transition or interface. Also other components of the packaged integrated circuit may have an impact on the distortion of the signal quality. For instance, discontinuities of a characteristic impedance of the packaged integrated circuit may also be caused by signal transmission lines or an interaction between different parts thereof. In the case of differential pairs (i.e. two signal lines transporting a signal in a differential manner), an interaction between such lines may also be the origin of a parasitic capacitance. An adaptation of a property of signal transmission lines (for example a distance between two lines of a differential pair, a height of a metallic structure forming a signal transmission line, a thickness and therefore a mass of a metallic structure forming a signal transmission line) may also be performed reducing (or even optimizing) corresponding discontinuities in the impedance behaviour.

According to an exemplary embodiment of the invention, the signal transmission quality of a packaged integrated circuit to be designed can be improved by modelling the electric behaviour of such a moulded chip, analyzing a behaviour of a test signal to be applied to such a model and then changing, if necessary, one or more design parameters so that discontinuities of a characteristic impedance of the packaged integrated circuit can be reduced. The present inventors have recognized that such discontinuities of the characteristic impedance of a moulded chip is one important source for deteriorating a signal quality of a signal to be transmitted using the packaged integrated circuit. A simple passive solution to improve this signal quality without additional circuitry and additional power dissipation can be obtained by improving the transmission line characteristic impedance of the packaged integrated circuit as well as adding, if necessary, one or more compensation inductors to the integrated circuit.

The inventors have recognized that an interface between a die and a package as well as an interface between the package and an electronic device (such as an application board) on which the packaged die is mounted are candidates for deteriorating a quality of a signal transmitted over such interfaces or barriers by adding noise to the signal. It is presently believed that such a deterioration may result from a capacitance added to the signal transmission path by such interfaces. In an embodiment, undesired effects resulting from such a capacitance may be at least partially compensated by correspondingly adapting a design of the packaged integrated circuit for reducing discontinuities of the characteristic impedance resulting from the mentioned barriers This can be done by electrically modelling a packaged integrated circuit, simulating a signal transmission over the modelled electric system, and adapting one or more design parameters of the packaged integrated circuit to compensate for discontinuities of the characteristic impedance.

In an embodiment, it is possible to optimize a transmission line of a packaged chip by means of the adding additional induction by using one or more coils. The above method and especially a corresponding simulation part is a preferred embodiment of achieving this goal. Of course, other ways to optimize this are possible, for instance to do this emperical (trial and measure).

Next, further exemplary embodiments of the method will be explained. However, these embodiments also apply to the packaged integrated circuit, to the program element and to the computer-readable medium.

The packaged integrated circuit may comprise a data transmitter in the form of an integrated circuit (chip). Such a data transmitter may be adapted for transmitting data with a high speed. It is also possible that the packaged integrated circuit comprises bond wires via which the integrated circuit may be connected to a package. Also bumps of the packaged integrated circuit and balls such as solder balls of the packaged integrated circuit may be components having an influence of the characteristic impedance. Therefore, also these components may be considered for the electric model. Moreover, vias penetrating a laminate substrate serving as a package may also contribute to the electric properties of the packaged integrated circuit so that also these vias can be taken into account. The electric model may therefore include one or two or more or all of the mentioned and/or of other components.

The method may further comprise analyzing a signal quality of the transmission line of the electric signal by the packaged integrated circuit based on the electric model. For this purpose, it is possible to theoretically apply a sequence of signals such as a sequence of test signals to the packaged integrated circuit to be designed, for instance using a simulation computer program. Then, upon application of such test signals, the response of the system may be analyzed with regard to the transmission of data and particularly deteriorations during this transmission. It is additionally or alternatively also possible to construct an integrated test circuit, package this circuit and apply the test signals to such a real integrated circuit experimentally.

Particularly, the analyzing may comprise calculating an eye-pattern of the transmission of the electric signal by the packaged integrated circuit. An eye-pattern, which may also be denoted as an eye diagram, may be an oscilloscope display in which a digital data signal from a receiver is repetitively sampled and applied to a vertical input, while the data rate is used to trigger the horizontal speed. It is called eye-pattern because, for several types of coding, the pattern looks like a series of eye between a pair of rails. Quality of signal transmission can be derived with high accuracy by analyzing an eye pattern. Furthermore, the eye-pattern in its characteristic is properly appropriate for being supplied to an automatic data evaluation system which, on the basis of this eye-pattern, can then determine the quality of a corresponding signal transmission. For this purpose, one or more features in the eye-pattern may be defined as decision criteria based on which an evaluation of the quality can be determined. For instance, the steepness of a raising edge, the steepness of a falling edge, a slope of a signal, etc. may be used as such features.

In an embodiment, the method may comprise modifying the packaged integrated circuit for adjusting an impedance of a transmission line of the packaged integrated circuit. By modelling the impedance characteristic of the transmission line, its impedance characteristic may be manipulated in a way to improve the signal quality. The term "transmission line" may particularly denote a signal carrying circuit or circuit component with controlled electrical characteristics used to transmit signals. Thus, a transmission line may be denoted as an arrangement of two or more conductors or a waveguide used to transform signal energy from one location to another. After having performed such a manipulation, it can be determined experimentally or theoretically whether the manipulation improves or worsens the signal quality. Worsening changes can be rejected, improving modifications can be accepted.

The modifying of the packaged integrated circuit may comprise adding an impedance, particularly adding an in substrate impedance, for at least partially compensating a capacitance formed at a signal interface between the integrated circuit and the package of the packaged integrated circuit. Optionally, also a capacitance formed at a signal interface between the package and a connected application board may be taken into account. The impedance may be added to the integrated circuit, to the package or to an application board. Particularly, such an additional impedance is a passive component which does not provide a dedicated function in an integrated circuit but is intentionally added for signal improvement purposes. Providing an additional inductance may allow to at least partially compensate the undesired effect of a capacitance formed by different portions of a signal transmission line and/or by a barrier (such as an interface between die and package and/or an interface between package and an application board). In other words, one or more inductances may be added for at least partially compensating the effect of capacitances including the effect of discontinuities.

More particularly, the added impedance may comprise an inductor member. An inductor member may be an electrical device or component that introduces a defined amount of inductance into a circuit. An inductor may also be denoted as a passive electronic component that stores energy as a magnetic field. Such an inductor may be a conducting coil. It may be preferred to use a planar coil in a surface portion of the integrated circuit as the substrate impedance. This allows for a space-efficient arrangement of the in substrate impedance. It is particularly preferred to use a spiral coil for such an impedance which can be formed in a surface of the integrated circuit. However, as an alternative to a spiral coil (for instance with a circular cross section, a rectangular cross section, etc.), it is also possible to form the inductor as a meander, with an 8-shape, etc. Although the compensation inductor may be planar, it is alternatively possible to arrange the compensation inductor to extend vertically over multiple (for instance four) layers in the substrate of the IC or the package. The compensation inductor may be provided on and/or in a semiconductor substrate of the integrated circuit (for instance in one or more top metallization layers thereof), on and/or in the package housing the integrated circuit (for instance in one or more top metallization layers thereof), and/or part of an application board on which the packaged integrated circuit may be mounted. Providing the compensation inductor as part of the packaged integrated circuit has the advantage that a customer does not have to care about such a compensation on the application board level. It may be advantageous to arrange the compensation inductor downstream (in the signal path) of drivers on the integrated circuit.

According to an exemplary embodiment, the method may comprise modifying the packaged integrated circuit for at least partially compensating reflections generated on vias, a ballpad, and/or balls of the packaged integrated circuit. The described components are particularly candidates for undesired reflections of signals which may deteriorate the quality of a transmitted signal. Since these candidates for undesired reflections dominate the discontinuities of the impedance characteristic, an embodiment may keep all components constant and only concentrate on vias, ballpads and balls for performing an optimization. By reducing the degrees of freedom to these components, a very efficient increase of the quality may be achieved.

The modifying may comprise running simulations with a number of different values of the impedance of a transmission line of the packaged integrated circuit and selecting a most appropriate impedance value. Thus, the system may be computer-implemented and may be based on predefined algorithms.

In an embodiment, the method comprises determining the electric model of the packaged integrated circuit and of an application board to which the packaged integrated circuit is connectable or connected, and analyzing the characteristic of the transmission of the electric signal by the packaged integrated circuit and by the application board based on the electric model. Hence, not only an internal interface within the packaged integrated circuit may be taken into account, but also an external interface between the packaged integrated circuit and a connected application board.

In an embodiment, the packaged integrated circuit may comprise a high speed data transmitter. Such high speed data transmitters may be used for HDMI (High Definition Multimedia Interface) applications, PCI (Peripheral Component Interconnect) express and display port in laminate based packages such as BGA (Ball Grid Array) or LFBGA. BGA may denote a surface mount package that utilizes an array of metals, spheres or balls as the need of providing external electrical interconnection. The balls may be composed of solder and may be attached to a laminated substrate at the bottom side of the package. The die of the BGA may be connected to the substrate by wire bonding or flip-chip connection. The substrate of a BGA may have internal conductive traces that may route and connect the die to substrate bonds to the substrate to ball array bonds.

Embodiments of the invention may be used for all applications in which signal transmission is performed. More precisely, exemplary embodiments are used particularly advantageously for serial protocols that bring data in and out. Examples for applications are any kinds of processors, computers, mobile phones, memory interfaces, etc. The packaged integrated circuit may form part of any electronic device, particularly may form part of a portable device. For instance, an embodiment may be or may be part of a mobile phone, a headset, a headphone playback apparatus, a hearing aid, a gaming device, a laptop, an audio player, a DVD player, a CD player, a harddisk-based media player, a radio device, an internet radio device, an MP3 player, a medical communication system, a body-worn device, or a speech communication device. Other applications are possible as well.

In an embodiment, compensation (for instance in substrate compensation) for a capacitive loading of an IC-package to an application board interface may be performed. An embodiment improves the signal quality on the package pins of high speed data transmitters such as used for HDMI, PCI-express and DisplayPort in laminate based packages such as BGA, LFBGA by
1) optimization of the transmission line characteristic impedance
2) addition of a in substrate spiral coil.

The optimized transmission line impedance or the impedance of the coil compensates the reflections generated on the vias (to change metal layer) ballpad and balls.

These and other aspects of the invention are apparent from and will be elucidated with reference to the embodiments described hereinafter.

### BRIEF DESCRIPTION OF THE DRAWINGS

The invention will be described in greater detail hereinafter, by way of nonlimiting examples, with reference to the embodiments shown in the drawings.
Fig. 1 illustrates a packaged integrated circuit having a bondwire and being designed by a method of designing a packaged integrated circuit according to an exemplary embodiment of the invention.
Fig. 2 is a flow chart which illustrates a method of designing a packaged integrated circuit according to an exemplary embodiment of the invention.
Fig. 3 and Fig. 4 illustrate an eye-pattern which can be acquired for designing a packaged integrated circuit according to an exemplary embodiment of the invention.
Fig. 5 shows an eye-pattern of a HDMI transmitter in a BGA package and the eye-pattern of a simulation according to an exemplary embodiment.
Fig. 6 illustrates an in substrate inductor coil formed in a surface portion of a packaged integrated circuit according to an exemplary embodiment.
Fig. 7 shows a plot illustrating the inductance behaviour of a chip depending on the frequency.
Fig. 8 illustrates a packaged integrated circuit having a flip-chip connection and being designed by a method of designing a packaged integrated circuit according to another exemplary embodiment of the invention.

### DESCRIPTION OF EMBODIMENTS

The illustration in the drawing is schematically. In different drawings, similar or identical elements are provided with the same reference signs.

In the following, some basic recognitions of the present inventors will be summarized based on which exemplary embodiments of the invention have been developed.

High speed transmitters such as used for HDMI, PCI-express and DisplayPort can be packaged in laminate based packages such as BGA, LFBGA. High speed signals in the Gbps (Giga bit per second) range are transmitted via transmission lines with characteristic impedances equal to or close to the terminating impedance to avoid reflections which are degrading the transmitted signal quality. Discontinuities of the characteristic impedance are found at bondwires or bumps of flip-chip dies, vias to other metal layers of the laminate and package balls and generate reflections. The reflections are affecting the signals at the pins such that the signals are not compliant to the standard of the specific interface. The signal quality is usually improved by applying additional pre-emphasis compensating the inpackage effects. The pre-emphasis requires additional circuitry and extra current and/or higher power supply voltage increasing the total power dissipation.

An embodiment of the invention provides a simple passive solution to improve the signal quality without complex additional circuitry and additional power dissipation.

In packaging, discontinuities of the characteristic impedance generate reflections. The reflections are affecting the signals such that the signals are not compliant to the standard of the specific interface. According to an embodiment of the invention, these reflections can be compensated for by
1) optimization of the transmission line characteristic impedance, and/or
2) addition of a in substrate spiral coil.

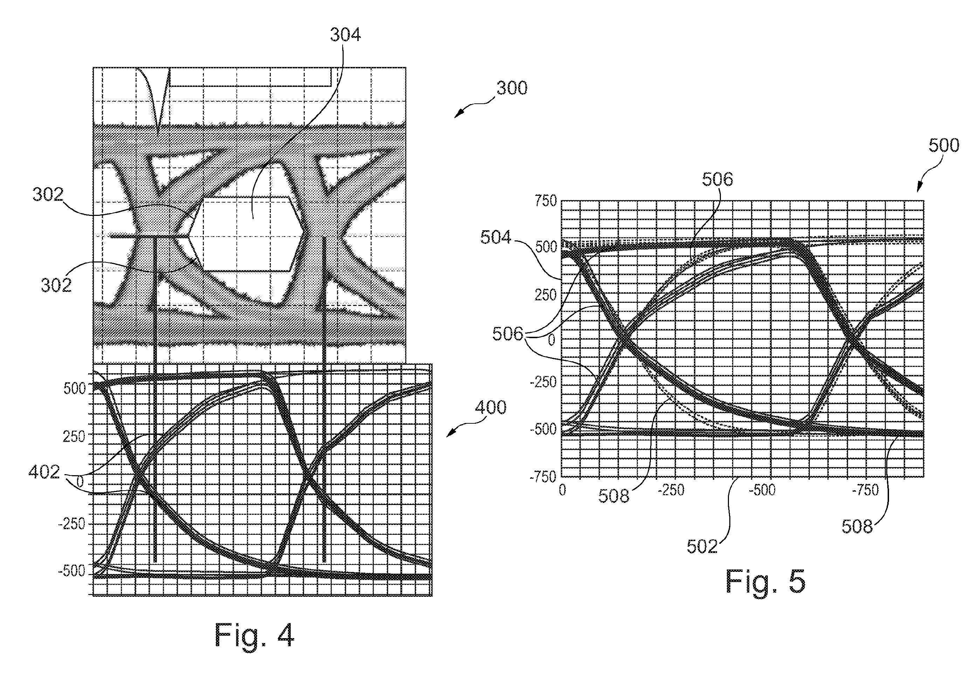

With regard to 1), the optimal value of the characteristic impedance for a specific case can be determined by using an electrical simulation program. The program may require electrical models of the transmitter, bondwires, bumps, transmission lines, vias and balls. The simulation program calculates the so called eye-patterns to observe the signal quality. For instance Fig 5 shows a typical eye-pattern 506 of a HDMI transmitter in a BGA-package and the eye-pattern of a simulation 508. The optimal transmission line may be found by running simulations with a number of different values of the characteristic impedance of the transmission line. Fig. 5 shows the original eye-pattern 506 with the characteristic impedance equal to the differential termination impedance of 100Ohm. The eye-pattern 508 has a package transmission line with a characteristic impedance of 200Ohm. The reflections due to mismatch are compensating the reflections on the vias and the BGA balls.

With regard to 2), addition of an in substrate spiral coil, the optimal value of the inductance for a specific case can be determined by using an electrical simulation program. The program may require electrical models of the transmitter, bondwires, bumps, transmission lines, coil, vias and balls. The simulation program calculates eye-patterns to observe the signal quality. The optimal inductance of the coil may be found by running simulations with a number of different values of the inductance of the coil. Similar eye-patterns may be created for the difference inductance value of the coil to find the optimum value.

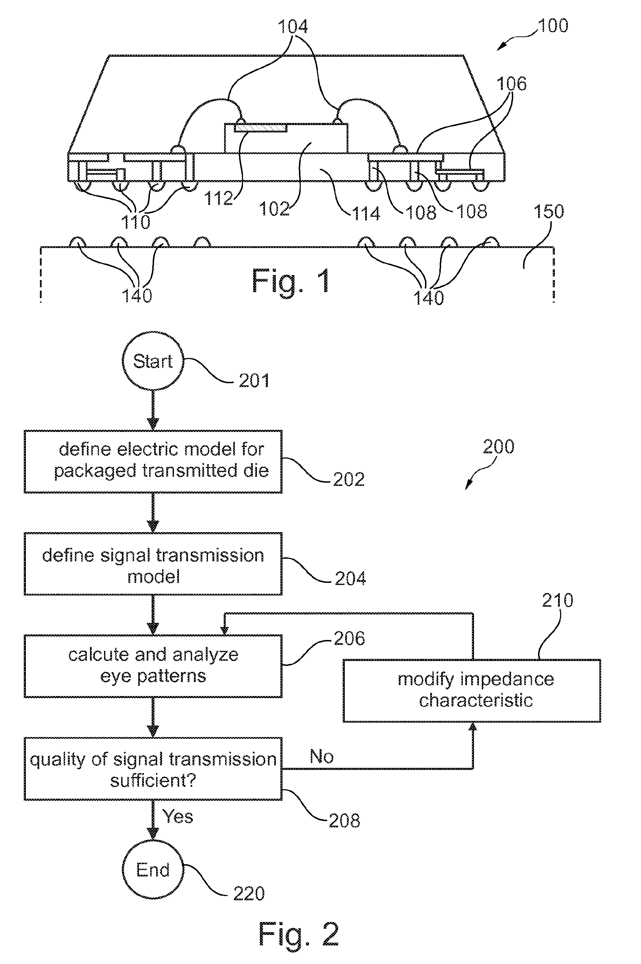

**Fig. 1** illustrates a packaged integrated circuit 100 for use as a high speed data transmitter being designed in accordance with a bondwire architecture using a method according to an embodiment of the invention. The arrangement of the various components of the packaged integrated circuit 100 may be determined by executing a method of designing a packaged integrated circuit according to an exemplary embodiment of the invention.

In one embodiment, a prototype of the packaged integrated circuit may first be manufactured in reality as a basis for a further improvement using the method. In another embodiment, the packaged integrated circuit may firstly be modelled virtually or theoretically as a basis for a further improvement using the method without having previously manufactured a packaged integrated circuit in reality.

By applying the method to a theoretical or practical model for a packaged integrated circuit, compensation for capacitive loading of IC-package to application board interfaces may be achieved. More particularly reflections of signals generated on individual components of the packaged integrated circuit 100 may be compensated for. This allows to obtain an optimized transmission line impedance for the packaged integrated circuit 100.

Before describing the method in further detail referring to Fig. 2, the packaged integrated circuit 100 will be described in more detail. As can be taken from Fig. 1, a semiconductor die 102 including the high speed data transmitter is attached, for instance adhered, to an interposer substrate or package 114. A number of vias 108 penetrate through the interposer substrate 114 comprising, inter alia, a number of patterned metallization layers 106 which may serve as portions of a transmission line for transmitting the signals. In other words, the vias 108 in combination with the transmission lines 106 provide for the electrical connection between an upper surface of the interposer substrate 114 and a lower surface of the interposer substrate 114. Two bond wires 104 electrically connect metallization pads provided on a top surface of the die 102 with corresponding transmission lines 106 on the upper surface of the interposer 114. At the lower surface of the interposer 114, a number of solder balls 100 are formed which can be electrically and mechanically connected to correspondingly shaped and arranged solder balls 140 of a circuit board 150 (or application board) to which the packaged integrated circuit 100 can be mounted to provide for a mechanical and an electrical connection.

Particularly an interface (including the bondwires 104) between die 102 and package 114 as well as an interface (including solder balls 110, 140) between package 114 and application board 150 are considered as potential sources of parasitic capacitances resulting in discontinuities of the characteristic impedance of the packaged integrated circuit 100 which may have an impact on the signal transmission properties over these interfaces.

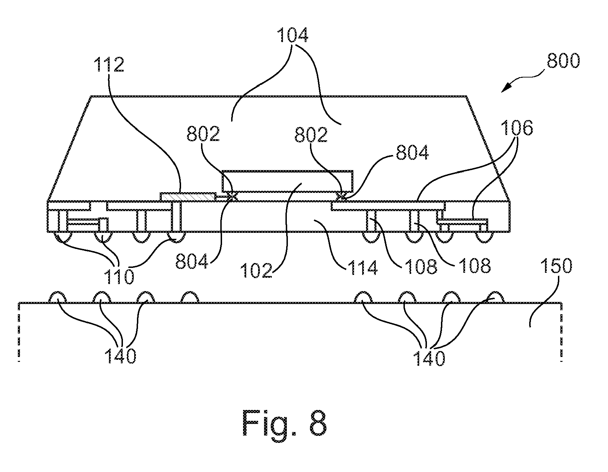

A spiral coil 112 is monolithically integrated in a surface portion of the die 102. Additionally or alternatively, spiral coil 112 may also be integrated in the interposer substrate 114 (see for instance the embodiment of Fig. 8). The inductor 112 is configured selectively in order to compensate for undesired signal distortion effects resulting from discontinuities of a characteristic impedance in the packaged integrated circuit 100. The design of the inductor 112 in combination with the design, size and electrical properties of the other above-mentioned components of the packaged integrated circuit 100 can be determined by a method 200 which will be explained in the following referring to **Fig. 2**.

After starting the method 200 in a block 201, an electric model is defined for the packaged transmitter die 100 to be designed. For example, at the beginning of the method 200, the packaged integrated circuit only exists on a virtual level, i.e. is theoretically developed but has not yet been produced as a physical structure. Alternatively, at the beginning of the method 200, the packaged integrated circuit has already been produced as a physical prototype structure but shall be further improved. Hence, the virtual or physical packaged integrated circuit 100 is defined by a number of parameters which can be changed as design parameters during the method 200 for adjusting the performance of the packaged integrated circuit 100. Block 202 may denote a procedure of determining an electric model of the packaged integrated circuit 100. In this context, and referring again to Fig. 1, the data transmitter die 102, the bondwires 104, the transmission lines 106, the vias 108 and the solder balls 110 of the virtual packaged integrated circuit 100 are modelled electrically. In other words, an equivalent circuit for these components is determined. In a further refined embodiment, also the application board 150 may be included in the model.

In a subsequent procedure 204, a signal transmission model may be defined. In other words, a characteristic of a signal to be transported by the packaged integrated circuit 100 can be defined. This may include the definition of a data rate, signal amplitudes, signal sequences, etc. For design purposes, it is also possible to define one or more test signals or test signal sequences to be applied to the packaged integrated circuit 100 to be developed.

On the basis of the electrical model 202, and optionally including also the modelled transmission signals (compare 204), eye-patterns (or other signal transmission characteristics) may be calculated and analyzed in a block 206. More generally, the characteristic of the transmission of the modelled electric signal by the modelled packaged integrated circuit 100 may be considered in block 206. Features in the eye-patterns can be considered as a fingerprint of signal deteriorations which may occur due to discontinuities of the characteristic impedance or the like. Therefore, a comparison between actual eye-patterns and target eye-patterns can be performed as well in block 206.

Next, in a block 208, it may be determined whether the quality of the signal transmission obtained with the applied model, i.e. the electrical model and the signal model, is sufficient for a specific application. For this purpose, it is possible to define one or more decision criteria defining whether such a quality is considered to be sufficient. For example, the quality may be considered as sufficient when a deviation of the actual values in the eye-pattern deviate from target values less than a predefined threshold value. Another appropriate desision criteria is a steepness of a slope in the eye pattern.

Upon determining that the quality of the signal transmission is sufficient, the method is at the end 220.

If it is however determined that the quality is not sufficient, it is possible to modify the impedance characteristics in a block 210. More generally, it is possible to modify the virtual packaged integrated circuit 100 based on a result of the analyzing for reducing discontinuities of a characteristic impedance of the packaged integrated circuit 100. Particularly, an impedance of the transmission line 106 may be adjusted in block 210. It is also possible additionally or alternatively that one or more in substrate impedances 112 is or are added to the packaged integrated circuit 100. By taking this measure, it is possible to at least partially compensate reflections generated on vias 108, balls 110, etc. of the packaged integrated circuit 100.

The modified model may be input to block 206 for repeating blocks 206 and 208 in an iterative manner one or several times. If modifications improve the performance, they can be accepted, otherwise they can be rejected. The method may be ended (see block 220), if the obtained quality is considered sufficient.

**Fig. 3** shows a diagram 300 indicating eye-patterns.

Dots 302 defining corners of a rectangle 304 may indicate that the corresponding device does not perform well enough with regard to the transmission of signals.

**Fig. 4** shows other eye-patterns 400.

Signal portions 402 show that rising and falling slopes of the signals are not steep enough which is the result of signal disturbance effects. Such slow slopes may be caused by an interface between the integrated circuit and its package and/or by an interface between the package and a connected application board (for instance of a TV).

**Fig. 5** shows a diagram 500 having an abscissa 502 along which the time is plotted. Along an ordinate 504, an amplitude of a signal is plotted. An original eye-pattern is visible by a curve indicated with reference numeral 506. Curves 508, however, illustrate target eye-patterns in accordance with a package transmission line with a characteristic impedance of 200 Ohm. In contrast to this, curves 506 relate to a differential termination impedance of 100 Ohm. It can be seen that the quality of the signal can be significantly improved by correspondingly adjusting parameters of the packaged integrated circuit 100.

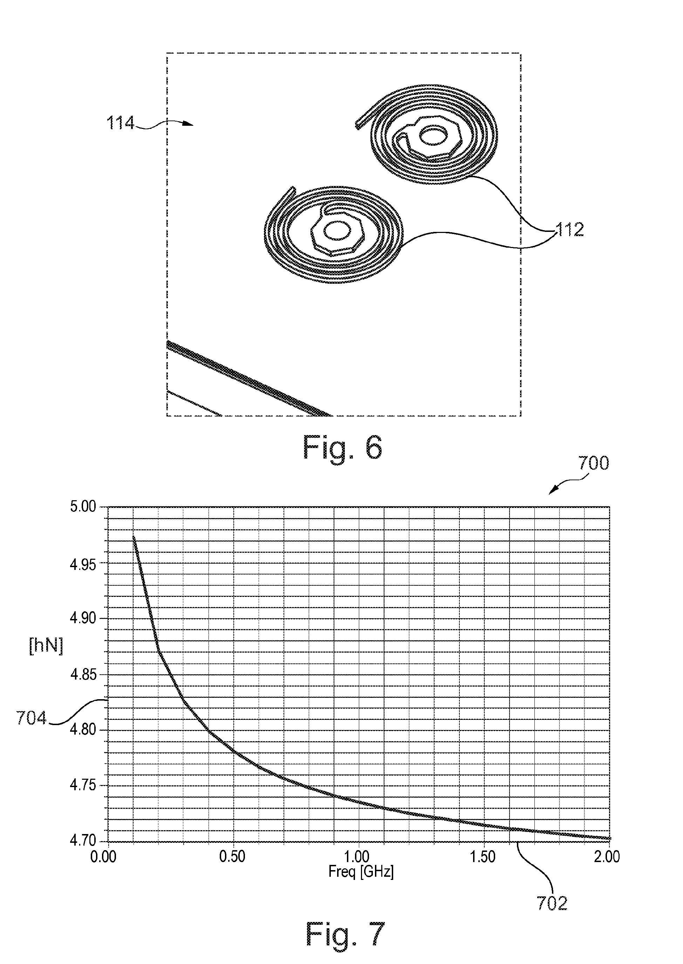

**Fig. 6** shows a plan view of interposer substrate 112. As can be taken from Fig. 6, in this case two spiral coils 112 are formed in a surface portion of the interposer substrate 112 for improving the characteristic of the high speed data transmitter.

A diagram 700 shown in **Fig. 7** has an abscissa 702 along which a frequency is plotted in GHz. Along an ordinate 704, an inductance value is plotted in nH.

**Fig. 8** illustrates a packaged integrated circuit 800 having a flip-chip connection and being designed by a method according to another exemplary embodiment of the invention.

In contrast to Fig. 1, packaged integrated circuit 800 does not have bondwires 104 but in constrast to this connects die 102 to package 114 via die bumps 802 bonded to correspondingly arranged and configured package bumps 804. Furthermore, the inductor coil 112 is formed on the package 114.

Finally, it should be noted that the above-mentioned embodiments illustrate rather than limit the invention, and that those skilled in the art will be capable of designing many alternative embodiments without departing from the scope of the invention as defined by the appended claims. In the claims, any reference signs placed in parentheses shall not be construed as limiting the claims. The word "comprising" and "comprises", and the like, does not exclude the presence of elements or steps other than those listed in any claim or the specification as a whole. The singular reference of an element does not exclude the plural reference of such elements and vice-versa. In a device claim enumerating several means, several of these means may be embodied by one and the same item of software or hardware. The mere fact that certain measures are recited in mutually different dependent claims does not indicate that a combination of these measures cannot be used to advantage.

## Claims

1. A method (200) of designing a packaged integrated circuit (100), the method comprising
determining (202) an electric model of the packaged integrated circuit (100); analyzing (206) a characteristic of a transmission of an electric signal by the packaged integrated circuit (100) based on the electric model;
modifying (210) the packaged integrated circuit (100) based on a result of the analyzing (206) for reducing discontinuities of a characteristic impedance of the packaged integrated circuit (100).

2. The method (200) according to claim 1, wherein the method comprises determining (202) the electric model of the packaged integrated circuit (100) by electrically modelling at least one of the group consisting of a data transmitter (102) of the packaged integrated circuit (100), bondwires (104) of the packaged integrated circuit (100), bumps (802, 804) of the packaged integrated circuit (800), transmission lines (106) of the packaged integrated circuit (100), vias (108) of the packaged integrated circuit (100), and balls (110) of the packaged integrated circuit (100).

3. The method (200) according to claim 1, wherein the method (200) comprises analyzing (206) a signal quality of the transmission of the electric signal by the packaged integrated circuit (100) based on the electric model.

4. The method (200) according to claim 1, wherein the analyzing (206) comprises calculating an eye-pattern of the electric signal to be transmitted by the packaged integrated circuit (100).

5. The method (200) according to claim 1, wherein the method (200) comprises modifying (210) the packaged integrated circuit (100) for adjusting an impedance of a signal transmission path of the packaged integrated circuit (100).

6. The method (200) according to claim 1, wherein the modifying (210) of the packaged integrated circuit (100) comprises adding an impedance (112) for at least partially compensating a capacitance formed at a signal interface between the integrated circuit (102) and the package (114) of the packaged integrated circuit (100).

7. The method (200) according to claim 6, wherein the added impedance (112) comprises an inductor, particularly a planar coil, more particularly a spiral coil.

8. The method (200) according to claim 6, wherein the added impedance (112) forms part of one of the group consisting of the integrated circuit (102) of the packaged integrated circuit (100), the package (114) of the packaged integrated circuit (100), and an application board (150) to be connected to the packaged integrated circuit (100).

9. The method (200) according to claim 1, wherein the method (200) comprises modifying (210) the packaged integrated circuit (100) for at least partially compensating reflections generated on at least one of the group consisting of vias (108), a ballpad, and balls (110) of the packaged integrated circuit (100).

10. The method (200) according to claim 1, wherein the modifying (210) comprises running simulations with a number of different values of the impedance of a transmission line (106) of the packaged integrated circuit (100) and selecting a most appropriate impedance value.

11. The method (200) according to claim 1, wherein the method comprises
determining (202) the electric model of the packaged integrated circuit (100) and of an application board (150) to which the packaged integrated circuit (100) is connectable;
analyzing (206) the characteristic of the transmission of the electric signal by the packaged integrated circuit (100) and by the application board (150) based on the electric model.

12. A packaged integrated circuit (100), comprising:
an integrated circuit (102);
a package (114) housing the integrated circuit (102) and being adapted for electrically coupling the integrated circuit (102) to an application board (150) to be mechanically connected to the packaged integrated circuit (100);
a transmission line (104, 106, 108, 110) along which an electric signal is to be coupled between the integrated circuit (102) and the application board (150);
at least one inductor (112) configured for at least partially compensating a capacitance formed at a signal interface between the integrated circuit (102) and the package (114) of the packaged integrated circuit (100).

13. The packaged integrated circuit (100) according to claim 12, designed by a method (200) according to claim 1.

14. A computer-readable medium, in which a computer program of designing a packaged integrated circuit (100) is stored, which computer program, when being executed by a processor, is adapted to carry out or control a method (200) according to claim 1.

15. A program element of designing a packaged integrated circuit (100), which program element, when being executed by a processor, is adapted to carry out or control a method (200) according to claim 1.
